# EUROPEAN PATENT SPECIFICATION

(11) **EP 3 491 164 B1**
(45) Date of publication and mention of the grant of the patent: **15.05.2024**
(21) Application number: 17768957.7
(22) Date of filing: 01.04.2017
(51) Int. Cl.: H10K 71/16, C23C 14/24, C23C 14/54, C23C 14/26, C23C 14/12

(54) **EVAPORATOR, EVAPORATION COATING APPARATUS AND EVAPORATION COATING METHOD**
VERDAMPFER, VERDAMPFUNGSBESCHICHTUNGSVORRICHTUNG UND VERDAMPFUNGSBESCHICHTUNGSVERFAHREN
ÉVAPORATEUR, APPAREIL DE REVÊTEMENT PAR ÉVAPORATION ET PROCÉDÉ DE REVÊTEMENT PAR ÉVAPORATION

(30) Priority: 27.07.2016 CN 201610605160
(43) Date of publication of application: 05.06.2019
(73) Proprietor: BOE Technology Group Co., Ltd., Beijing 100015 (CN)
(72) Inventor: ZHAO, Dejiang, Beijing 100176 (CN)
(74) Representative: Isarpatent
(86) International application number: PCT/CN2017/079293
(87) International publication number: WO 2018/018926

(56) References cited:
- EP-A1- 2 025 774
- EP-B1- 2 025 774
- CN-A- 1 348 509
- CN-A- 103 469 172
- CN-A- 105 177 507
- CN-A- 106 119 781
- CN-U- 203 976 897
- CN-U- 204 384 296
- JP-A- 2014 524 975
- US-A1- 2009 288 600
- US-A1- 2010 122 658
- US-A1- 2010 206 234
- US-B2- 7 625 602

## Description

### CROSS-REFERENCE TO RELATED APPLICATION

The present application claims priority to Chinese Patent Application No. 201610605160.8 filed on July 27, 2016, the disclosure of which is hereby incorporated by reference in its entirety.

### TECHNICAL FIELD

The present disclosure is related generally to the field of coating technologies, and more specifically to an evaporator, an evaporation coating apparatus, and a method of evaporation coating.

### BACKGROUND

An evaporation coating equipment, or an evaporation deposition equipment, is a device that is frequently used to coat an object. The object to be coated can be an electronic component, such a substrate of an electronic apparatus. The object can be coated with the a source material to form a coating layer, a film, or a membrane of specified composition and thickness. The evaporation coating equipment is frequently employed during fabrication of some electronic devices, such as an organic light-emitting diode (OLED) display panel.

A typical evaporation coating apparatus usually includes a coating chamber, and an evaporator disposed in the coating chamber. The coating chamber is configured to provide an environment (such as a vacuum) for coating, and the evaporator is configured to evaporate a source material (i.e., a coating material) such that the source material vapor can attach to, or deposit onto, the substrate, thereby forming a layer or a film of the source material on the substrate.

In a conventional evaporation coating technology, the evaporator typically includes a furnace and a heating wire. The furnace is usually configured to provide a space for holding a source material, i.e., the source material is typically placed in the furnace. The heating wire is usually arranged to surround the furnace and is configured to heat the furnace.

During the process of evaporation coating, after the coating chamber is opened, the source material is disposed in the furnace, and the substrate is disposed over the furnace. After the coating chamber is closed, the furnace is heated by means of the heating wire. Upon heating, the source material is evaporated and the source material vapor becomes attached onto (or deposits) the substrate to thereby obtain a coated substrate having a layer of the source material coated thereon. Finally, the coated substrate is taken out of the coating chamber.

### SUMMARY

The inventors of the present disclosure have recognized the following issues with respect to conventional evaporation coating technologies such as the one as described above. If there is a relatively large amount of source material, the source material tends to be piled together, and if there is further an uneven heating, some of the source material can become carbonized. These effects can severely influence the normal evaporation coating process, and can also result in a waste of source materials.

More specifically, the evaporator is typically disposed inside a coating chamber, and in order to prevent the air in the environment from contaminating the coating chamber, the coating chamber is not opened once the evaporation coating process starts. As such, all of the source material needs to be placed in the furnace, but this can lead to a relatively large amount of the source material being piled up in the furnace. As such, it holding a source material, i.e., the source material is typically placed in the furnace. The heating wire is usually arranged to surround the furnace and is configured to heat the furnace.

During the process of evaporation coating, after the coating chamber is opened, the source material is disposed in the furnace, and the substrate is disposed over the furnace. After the coating chamber is closed, the furnace is heated by means of the heating wire. Upon heating, the source material is evaporated and the source material vapor becomes attached onto (or deposits) the substrate to thereby obtain a coated substrate having a layer of the source material coated thereon. Finally, the coated substrate is taken out of the coating chamber.

US 2010/206234 A1 relates to metering of particulate materials, over a large range of feed rates, into a vaporization apparatus.

US 2009/288600 A1 relates to an apparatus for supplying a source, which can quantitatively supply a powder source that is a deposition material, and an apparatus for depositing a thin film having the same.

US 7 625 602 B2 relates to controllably feeding material to a heated surface.

EP 2 025 774 A1 relates to the technology for producing organic films having high quality.

US 2010/122658 A1 relates to metering of small particle size powdered materials, over a large range of feed rates, into a vaporization apparatus.

CN 105 177 507 A relates to a vapor deposition crucible and vapor deposition equipment to improve the utilization rate of vapor deposition materials and improve the efficiency of vapor deposition.

CN 204 384 296 U relates to a rigid impeller feeder with rollers.

CN 203 976 897 U relates to an evaporation source device and a vacuum evaporation equipment.

### SUMMARY

The inventors of the present disclosure have recognized the following issues with respect to conventional evaporation coating technologies such as the one as described above. If there is a relatively large amount of source material, the source material tends to be piled together, and if there is further an uneven heating, some of the source material can become carbonized. These effects can severely influence the normal evaporation coating process, and can also result in a waste of source materials.

More specifically, the evaporator is typically disposed inside a coating chamber, and in order to prevent the air in the environment from contaminating the coating chamber, the coating chamber is not opened once the evaporation coating process starts. As such, all of the source material needs to be placed in the furnace, but this can lead to a relatively large amount of the source material being piled up in the furnace. As such, it can easily result in the carbonization of some of the source material. This is further compounded by the uneven temperature.

In order to address the issues associated with current evaporation coating technologies, the present disclosure provides an evaporator, an evaporation coating can easily result in the carbonization of some of the source material. This is further compounded by the uneven temperature.

In order to address the issues associated with current evaporation coating technologies, the present disclosure provides an evaporator, an evaporation coating apparatus, and a method of evaporation coating.

In a first aspect, an evaporator is disclosed.

The evaporator comprises at least one feeding member and a heating member. Each feeding member is configured to transfer a source material in a transfer speed that is adjustable. The heating member is configured to heat the source material transferred by the feeding member for evaporation to thereby generate a source material vapor.

In some embodiments of the evaporator, each feeding member is configured to transfer the source material to the heating member in portions, wherein each portion of the source material is transferred to the heating member in a time period, and the time period for each portion is adjustable to thereby realize that the transfer speed is adjustable.

As such, in the evaporator, the source material can be in a form of grains, and each feeding member can comprise a dispenser, which is configured to adjustably dispense the grains of the source material to allow the source material to be transferred to the heating member.

In order to adjustably dispense the grains of the source material as described above, the dispenser can comprise a vane wheel, and the vane wheel is configured to rotate to thereby dispense the grains of the source material for transferring to the heating member. As such, the vane wheel can be coupled with a controller, which is configured to adjust a rotation speed of the vane wheel to thereby realize that the transfer speed of the source material is adjustable.

In some embodiments of the evaporator, each feeding member comprises a storage portion and a transfer portion. The storage portion is configured to store the source material before transferring to the transfer portion; and the transfer portion is configured to transfer the source material from the storage portion to the heating member.

The storage portion can comprise a preheating subportion, which is configured to preheat the source material in the storage portion.

In the above mentioned embodiments, the evaporator can further include an evaporation chamber. As such, the heating member can be disposed inside the evaporation chamber. The storage portion of each feeding member can be disposed outside the evaporation chamber. The evaporation chamber can be provided with a vapor outlet, which is configured to vent the source material vapor out of the evaporation chamber for subsequent coating onto a substrate.

The evaporation chamber can be provided with a temperature controlling portion, configured to maintain a temperature of the evaporation chamber to thereby prevent the source material vapor from solidifying on an inner side of the evaporation chamber. The temperature controlling portion as described above can comprise a heating wire surrounding the evaporation chamber.

In some embodiments of the evaporator, the evaporation chamber comprises a vapor flow stabilizing plate. The vapor flow stabilizing plate is disposed inside the evaporation chamber to separate the heating member and the vapor outlet, and provided with a plurality of openings, which are configured to allow the source material vapor generated from the heating member to move therethrough to subsequently vent out of the evaporation chamber through the vapor outlet.

In some embodiments of the evaporator as mentioned above, each opening of the vapor flow stabilizing plate has a substantially same size and shape, and a region closer to a center of the vapor flow stabilizing plate is configured to have a higher distribution density of openings.

In some embodiments of the evaporator, each feeding member can be configured to transfer a source material of a parameter, wherein the parameter comprises at least one of a composition, a shape, or a size. As such, each feeding member can be configured to transfer one different type of source material (i.e. having different compositions), or can be configured to transfer a same type source material, but with different shapes or sizes.

In some embodiments of the evaporator, the heating member comprises a heating groove. As such, the source material from the at least one feeding member can be transferred into the heating groove, and the heating groove can comprise a bottom wall, and a side wall surrounding an edge of the bottom wall, wherein the bottom wall and the side wall are configured to be both able to heat.

In a second aspect, the present disclosure further provides an evaporation coating apparatus.

The evaporation coating apparatus comprises an evaporator according to any one of the embodiments as described above.

According to some embodiments of the present disclosure, the evaporation coating apparatus further comprises a coating chamber, an object holder, and a controller configured to control the transfer speed.

The evaporator and the object holder are both disposed inside the coating chamber. The object holder is configured to provide a platform for placing an object to be coated thereon. The coating chamber is configured to provide an environment for the source material vapor vented out from the evaporator to attach to the object to thereby form a film of the source material onto the object.

According to some embodiments of the present disclosure, the evaporation coating apparatus further comprises a film thickness detector, which is configured to detect a rate of thickness change for the film of the source material coated onto the substrate. As such, the film thickness detector as described above can comprise a crystal oscillator.

In a third aspect, the present disclosure further provides a method for evaporation coating of a source material on an object utilizing an evaporation coating apparatus.

The evaporation coating apparatus as utilized in the above mentioned method comprises an evaporator, a coating chamber, and an object holder, wherein the evaporator comprising at least one feeding member and a heating member.

The method comprising the following steps:
placing the source material in the at least one feeding member and closing off the coating chamber;
starting the heating member until a temperature of the heating member is higher than a gasification temperature of the source material; and
the at least one feeding member transferring the source material to the heating member in a transfer speed that is adjustable to thereby obtain a source material vapor before the source material vapor attaches to the object to thereby form a film of the source material thereon.

Between the starting the heating member until a temperature of the heating member is higher than a gasification temperature of the source material and the at least one feeding member transferring the source material to the heating member in a transfer speed that is adjustable, the method can further comprise the following step:
adjusting a power of the heating member such that the temperature of the heating member is maintained at a level higher than the gasification temperature of the source material.

Prior to the at least one feeding member transferring the source material to the heating member in a transfer speed that is adjustable, the method can further comprise the following step:
preheating the source material.

In some embodiments of the method, the evaporation coating apparatus further comprises a film thickness detector configured to detect a rate of thickness change for the film of the source material coated onto the object. As such, in the method, the at least one feeding member transferring the source material to the heating member in a transfer speed that is adjustable can comprise the following sub-steps:
the at least one feeding member transferring the source material to the heating member;
periodically detecting a rate of thickness change for the film of the source material coated onto the object; and
adjusting a transfer speed of the source material based on the rate of thickness change for the film of the source material, such that a difference between the rate of thickness change and a preset rate of thickness change is smaller than a preset value.

In the method, the adjusting a transfer speed of the source material based on the rate of thickness change for the film of the source material can comprise the following sub-steps:
comparing the rate of thickness change for the film of the source material with a preset rate of thickness change; and
reducing the transfer speed of the source material if the rate of thickness change for the film of the source material is larger than the preset rate of thickness change; or
increasing the transfer speed of the source material if the rate of thickness change for the film of the source material is smaller than the preset rate of thickness change.

Other embodiments may become apparent in view of the following descriptions and the attached drawings.

### BRIEF DESCRIPTION OF THE DRAWINGS

To more clearly illustrate some of the embodiments provided in the present disclosure, the following is a brief description of the drawings. The drawings, as well as the descriptions thereof that follow, are only illustrative of some embodiments, and may not cover other embodiments. For those of ordinary skill in the art, drawings of other embodiments can become apparent based on these drawings.
FIG. 1 is a schematic diagram of an evaporator according to some embodiments of the present disclosure;
FIG. 2A is a schematic diagram of an evaporator according to some implementations of the present disclosure;
FIG. 2B illustrates a top plan view of the vapor flow stabilizing plate as shown in FIG. 2A;
FIG. 2C is a schematic diagram of an evaporator according to some other embodiments of the present disclosure;
FIG. 2D is a schematic diagram of a feeding member of the evaporator according to some embodiments of the present disclosure;
FIG. 3 is a flow chart of an evaporation coating method according to some embodiments of the present disclosure;
FIG. 4A is a flow chart of an evaporation coating method according to some other embodiments of the present disclosure;
FIG. 4B is a schematic diagram of an evaporation coating apparatus utilized in the evaporation coating method as shown in FIG. 4A;
FIG. 4C is a flow chart of adjusting a transfer speed of the source material according to some embodiments of the present disclosure.

The drawings as briefly described above provide an illustration of some of the embodiments provided in the present disclosure, and a detailed description of the drawings can be found in the following. It is noted that the drawings and the description thereof are for the purpose of illustration only, and do not impose limitations on the scope of the present disclosure.

### DETAILED DESCRIPTION

In the following, with reference to the drawings of various embodiments as disclosed herein, the technical solutions of the embodiments of the disclosure will be described in a clear and fully understandable way.

In order to address the issues associated with current evaporation coating technologies, such as the aforementioned issue of carbonization of the source material due to piling up of the source material and uneven heating, the present disclosure provides an evaporator, an evaporation coating apparatus, and a method of evaporation coating.

In a first aspect, an evaporator is disclosed. The evaporator comprises at least one feeding member and a heating member. Each feeding member is configured to transfer a source material to the heating member, wherein a transfer speed of the source material is adjustable. The heating member is configured to heat the source material transferred by the feeding member for evaporation to thereby generate a source material vapor.

According to some embodiments of the evaporator, each feeding member is configured to transfer the source material to the heating member in portions. For example, each portion is transferred in one time period, wherein the one time period for each portion is adjustable.

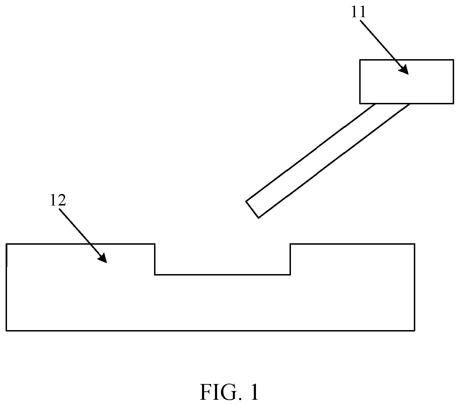

FIG. 1 illustrates an evaporator according to some embodiments of the present disclosure. As shown in FIG. 1, the evaporator comprises a feeding member 11 and a heating member 12.

The feeding member 11 is configured to store a source material and to feed, or transfer, the source material to the heating member 12 for n time periods, where n is an integer ≥ 2. In some embodiments, the n time periods are sequential and continuous time periods. In some other embodiments, the n time periods are not continuous, and can have time gaps in between. According to some embodiments, the n time periods each can have a same time span. According to some other embodiments, the n time periods can have different time spans. Similarly, the gaps between two consecutive time periods can have the same, or different, length. The sequence of the n time periods can be controlled, for example, digitally using a processor.

Correspondingly, the source material can be divided into a total of n portions, and the feeding member 11 can transfer one portion of the source material to the heating member for evaporation each time. The heating member 12 is configured to heat the source material transferred by the feeding member such that the source material is evaporated and becomes a source material vapor.

In the evaporator as described above, the feeding member is configured to transfer the source material to the heating member in portions, one time period for each portion. For example, the feeding member is configured to divide the source material stored therein into a plurality of portions for feeding to the heating member such that one portion of the source material is transferred to the heating member for evaporation to thereby turn into the source material vapor for each of the n time periods.

In some embodiments, each portion of the source material can have a substantially equal mass. According to some other embodiments, different portions can have different masses. The portion sizes can be controlled or programmed, for example, using a processor based on the specific needs.

In the embodiments of the evaporator as described above, through the feeding member 11, the source material can be divided into multiple portions. One portion of the source material can be fed to the heating member 12 each time period. As such, source material carbonization can be reduced. The consequent detrimental effects on the evaporation coating process resulting from the piling up of a relatively large amount of source material in the heating member, and to an uneven heating by the heating member as well, can also be effectively solved.

According to some embodiments as described above, because there is a relatively small amount of source material for evaporation during each time period in the heating member, a relatively even heating can be realized. Carbonization is of the source material in the heating member is therefore reduced or inhibited.

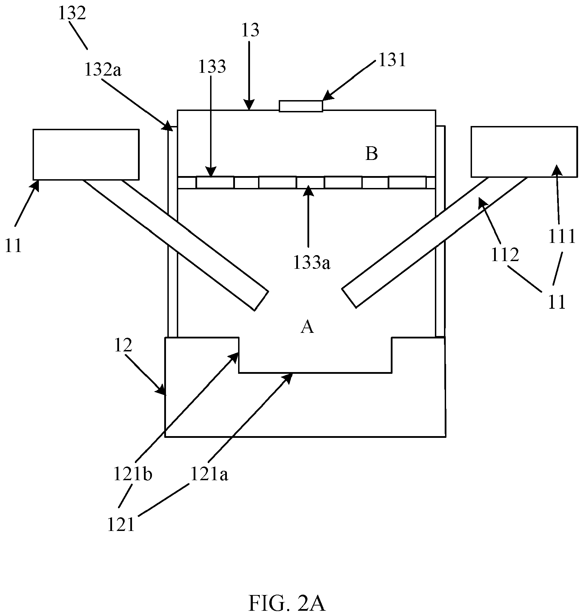

FIG. 2A illustrates an evaporator according to some implementations. As shown, the feeding member 11 can comprise a storage portion 111 and a transferring portion 112. The storage portion 111 is configured to store the source material, and the transferring portion 112 is configured to feed or transfer the source material to the heating member 12 for the n time periods.

In some embodiments, the source material can be an organic electro-luminescence (OEL) material. For example, the evaporator according to the aforementioned embodiments can be applied to form an organic layer of organic light-emitting diodes (OLEDs) on the to-be-coated object, such as a substrate. The substrate coated with the OLED material can be an important component of, for example, an OLED display.

According to some embodiments, the evaporator 10 can further comprise an evaporation chamber 13, wherein the heating member 12 is disposed inside the evaporation chamber 13. The evaporation chamber 13 is provided with a vapor outlet 131, which is configured to vent the source material vapor out of the evaporation chamber 13.

The substrate or object to be coated can be disposed directly over the vapor outlet 131. In an example, the feeding member 11 can feed the source material to the heating member 12 within a series of 5-10 time periods, to thereby realize a stable flow of the source material vapor.

Additionally, because the evaporator as described above can evaporate one portion of the source material each time, the efficiency of evaporation coating can be improved.

The storage portion 111 is arranged outside the evaporation chamber 13, so as to reducing heating of the storage portion 111 by the evaporation chamber, thereby avoiding detrimental effects on the source material from a higher temperature inside the storage portion 111.

According to some embodiments of the evaporator, the storage portion 111 can be provided with a preheating subportion 111a, which is configured to preheat the source material in the storage portion 111. The process of preheating can avoid a sharp increase of the temperature of the source material after the source material enters the heating member 12, which can damage the source material. The preheating temperature can be around 80 °C or around 50°C, and can be configured based on practical needs. The preheating subportion 111a can comprise a first heating wire surrounding the storage portion 111.

According to some embodiments of the evaporator, the evaporation chamber 13 can be provided with a temperature controlling portion 132, which is configured to control a temperature in the evaporation chamber 13. The temperature controlling portion 132 can comprise a second heating wire 132a, which is disposed to surround the evaporation chamber 13.

The second heating wire 132a is configured to maintain a relatively high temperature inside the evaporation chamber 13, to thereby prevent the source material vapor from solidifying while moving upward, and to prevent the source material vapor from solidifying and depositing onto an inner wall of the evaporation chamber 13 after the source material vapor contacts an inner wall of the evaporation chamber 13, which can result in a waste of the source material.

In some embodiments, the temperature controlling portion 132 can comprise other sub-portions, such as an electromagnetic heater or an infrared heater. There are no limitations herein.

According to some embodiments of the evaporator, the evaporation chamber 13 can be provided with a vapor flow stabilizing plate 133, which is disposed inside the evaporation chamber 13. The vapor flow stabilizing plate 133 is provided with a plurality of openings 133a. The evaporation chamber 13 can be partitioned into two cavities by the vapor flow stabilizing plate 133, wherein the heating member 12 is disposed in one of the two cavities (e.g., cavity A), and the vapor outlet 131 is connected to another one of the two cavities (e.g., cavity B). The plurality of openings 133a are configured to provide a passageway for the source material vapor generated by the heating member 12 in cabinet A to cabinet B.

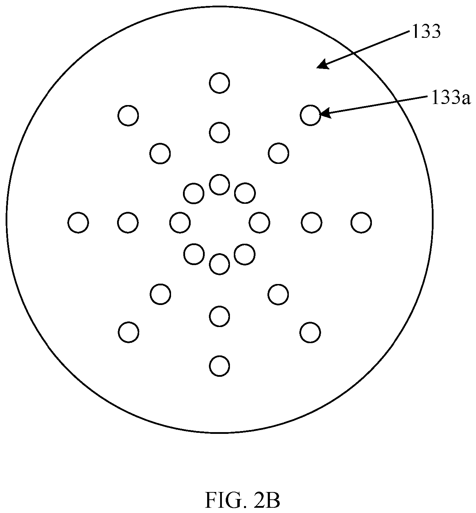

FIG. 2B illustrates a top view of the vapor flow stabilizing plate 133 shown in FIG. 2A according to some embodiments of the present disclosure. The plurality of openings 133a on the vapor flow stabilizing plate 133 are illustrated in FIG. 2B, wherein each of the openings 133a has a substantially same size and shape, and the closer the openings are to a center of the vapor flow stabilizing plate 133, the more openings 133a are arranged. That is, in the embodiment shown, the openings closer to the center of the vapor flow stabilizing plate 133 are arranged to have a higher distribution density.

Such a distribution of the plurality of openings 133a can be configured to allow the source material vapor to scatter to thereby prevent the source material vapor from gathering to negatively influence the coating effect. Therefore, the vapor flow stabilizing plate 133 effectively redistributes the source material vapor as desired.

It is noted that the sizes, shapes, and distribution of the openings 133a as described above and illustrated in FIG. 2B represent only some embodiments of the present disclosure. Other embodiments can have openings configured to be of different sizes, shapes, or distribution, and can be configured to scatter the source material vapor in a different distribution as desired.

As shown in FIG. 2A, the heating member 12 includes a heating groove 121, which comprises a bottom wall 121a and a side wall 121b that surrounds an edge of the bottom wall 121a. As such, the feeding member 11 can be configured to transfer the source material into the heating groove 121 of the heating member 12 within the n time periods.

The bottom wall 121a and the side wall 121b of the heating groove 121 can be configured to both heat the source material disposed therein, resulting in an improved heating effect to thereby elevating the evaporation speed. The heating groove 121 can heat via a manner of resistance wire heating (e.g., a third heating wire), or a manner of induction heating. In some embodiments, the heating member 12 can comprise components other than those as described above for heating. For example, the heating member 12 can include an electron-beam heater. There are no limitations on the manner and structure of heating by the heating groove 121.

According to some embodiments of the present disclosure, the evaporator 10 can include at least two feeding members 11, and each feeding member 11 is configured to store the source material and to transfer the source material to the heating member 12 for n time periods.

FIG. 2A illustrates an embodiment of the evaporator comprising two feeding members 11. In some embodiments, there can be more than two feeding members 11. For example, four, five, or more feeding members 11 can be included in the evaporator 10.

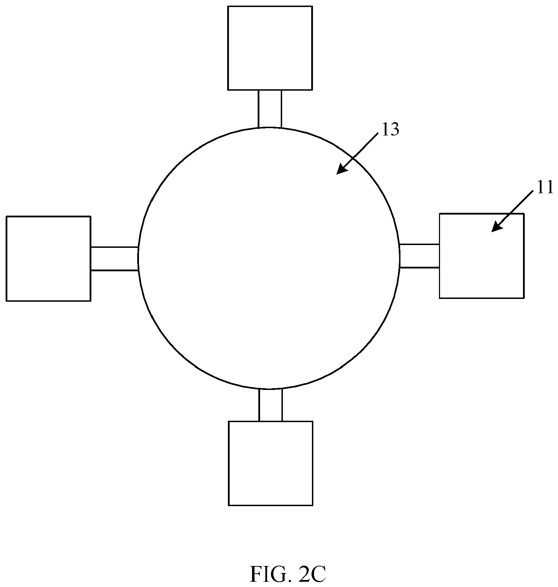

In the embodiment of the evaporator as shown in FIG. 2C, the evaporator comprises four feeding members 11, which are distributed evenly on a surrounding of the evaporation chamber 13. The number of feeding members in the evaporator is dependent on practical needs, and there are no limitations herein. The distribution of the feeding members 11 can also be uneven according to some embodiments.

In some embodiments of the evaporator, the source material stored in, and transferred by, the at least two feeding members 11 can be in a form of grains. The sizes and shapes of the grains can be configured based on practical needs.

In some embodiments, the source material can be in other forms so long as the source material can be divided into portions for discrete feeding to the heating member of the evaporator

The source material may also need pre-treatment, if taking a shape different from its original shape. For example, if an OLED material is used as the source material, because it can be originally in a form of powder, it may need to be pre-treated to take the form of grains.

The at least two feeding members 11 of the evaporator can be configured to store and transfer the source material of a different parameter. Herein, the parameter can include at least one of a composition, or a grain size, of the source material.

If the source material in each of the at least two feeding members 11 has a same composition but has a different grain size, each feeding member 11 can be controlled to feed the source material stored therein (i.e., the source material corresponding to the each feeding member 11) to the heating member 12, such that the amount of the source material transferred to the heating member 12 corresponding to each feeding member 11 can be accurately controlled to thereby allow the evaporation speed of the source material to be adjusted.

If the source material in each of the at least two feeding members 11 has a different composition, the evaporator can be configured to feed a first source material of a first composition for evaporation coating onto a first substrate, and then to feed a second source material of a second composition for evaporation coating onto a second substrate, and so on. Therefore, after evaporation coating of the first substrate with the first source material of the first composition, there is no need to replenish the source material, and the second substrate can be placed for direct evaporation coating with the second substrate of the second composition, and so on.

If the source material in each of the at least two feeding members 11 has a substantially same parameter, the evaporator having the at least two feeding members 11 as disclosed herein can thus store more of the source material than an evaporator according to a current technology.

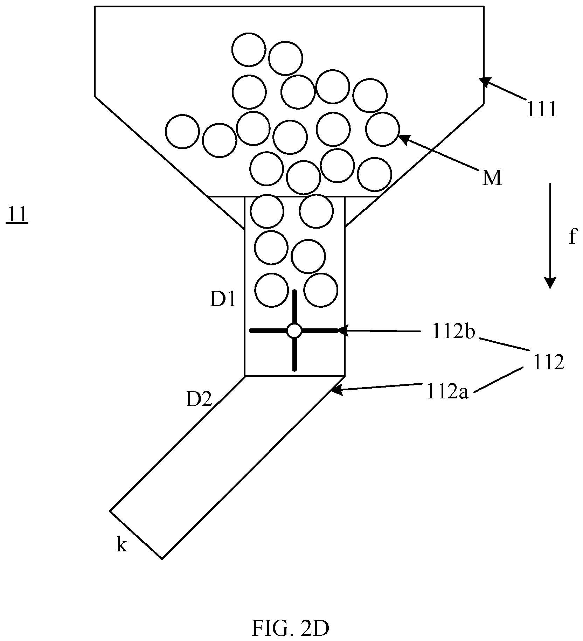

FIG. 2D illustrates a feeding member 11 according to some embodiments of the present disclosure. The feeding member 11 as shown in FIG. 2D can be employed in the evaporator 10 as shown in FIG. 2A or FIG. 2C.

As shown in FIG. 2D, the source material in the feeding member 11 is in a form of grains. The transfer speed of the source material can be adjusted, for example, by controlling a number of grains in each time period. In some other embodiments, each portion corresponds to one grain, and the transfer speed can be controlled by adjusting the time sequence of n time periods, such as the duration of each time period, the length of the gap between two consecutive time periods, etc.

In some embodiments, the feeding member 11 comprises a storage portion 111 and a transferring portion 112. The transferring portion 112 includes a feeding channel 112a and a vane wheel 112b.

The vane wheel 112b is disposed inside the feeding channel 112a and separates the feeding channel 112a into a first segment D1 and a second segment D2. The first segment D1 of the feeding channel 112a is connected to the storage portion 111 and is occupied or filled with the source material M. An opening k of the second segment D2 of the feeding channel 112a which is farther away from the vane wheel 112b is arranged over the heating member 12 (not shown in FIG. 2D).

The vane wheel 112b is configured to rotate in a controllable manner to thereby allow a preset number of grains of the source material (for example, one grain of the source material) to pass from the first segment D1 to the second segment D1, and further from the second segment D2 to the heating member 12.

It is noted that FIG. 2D illustrates only one embodiment of the vane wheel 112b. The vane wheel 112b can have other structures or shapes, and there are no limitations herein. It is further noted that besides the vane wheel 112b, a component having a function of dispenser that can dispense the source material in a controllable manner, can also be employed. There are no limitations herein.

According to some embodiments of the present disclosure, the storage portion 111 can have a shape of a funnel, such that one smaller opening of the storage portion 111 is connected to the first segment D1 of the feeding channel 112a. The storage portion 111 is further configured such that a direction of the source material exiting the storage portion (i.e., an exit direction of the source material) f is parallel to a gravitational direction. As such, the source material can spontaneously enter the transferring portion 112 from the storage portion 111 under the gravitational forces.

When the vane wheel 112b is rotating in the transferring portion 112, the source material can be transferred from the first segment D1 to the second segment D2 in the feeding channel 112a, and further from the second segment D2 to the heating member 12. The vane wheel 112b can be driven by a motor, and a rotating speed of the vane wheel 112b can be controlled by manipulating the motor to thereby control the feeding speed of the source material to the heating member 12.

It is noted that the configuration of the feeding member is not limited to that illustrated in FIG. 2D. In some other embodiments, the feeding member can take other configurations to realize a controllable dispensing of the source material from the storage portion 111 through the transferring portion 112 to the heating member 12.

For example, a dispenser other than a vane wheel 112b as shown in FIG. 2D can be employed. If a vane wheel 112b is employed, it can be disposed in a position other than in a middle of the feeding channel 112a of the transferring portion 112 as shown in FIG. 2D (for example, the end corresponding to the opening K, or the end corresponding to another opening of the feeding channel 112a that is connected to the storage portion 111). There are no limitations herein.

In the evaporator as described above, by means of the feeding member which can feed the source material to the heating member 12 for the n time periods, the issue of source material carbonization and the consequent negative effects on the evaporation coating process that is due to the piling up of a relatively large amount of source material in the heating member, and to an uneven heating by the heating member as well, can be effectively solved.

By means of the evaporator as mentioned above, because there is a relatively small amount of source material for evaporation in the heating member, a relatively even heating can be realized, the source material is thus not subject to carbonization, ensuring that the evaporation coating process can normally proceed.

In a second aspect, the present disclosure further provides an evaporation coating apparatus. The evaporation coating apparatus can include an evaporator according to the various embodiments as illustrated in FIG. 1, FIG. 2A, or FIG. 2C.

The evaporation coating apparatus further includes a coating chamber, and an object holder. The evaporator is disposed inside the coating chamber. The object holder is disposed inside the coating chamber and is configured to provide a platform for placing an object to be coated (such as a substrate) thereon.

In a third aspect, the present disclosure provides an evaporation coating method, which can utilize the evaporation coating apparatus as described above.

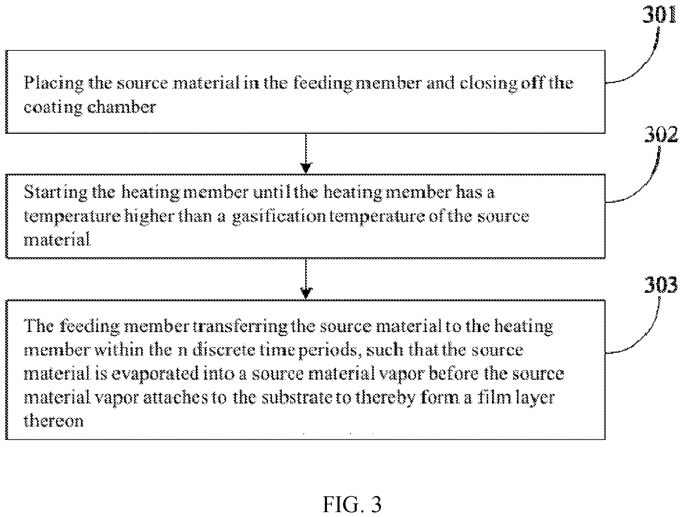

FIG. 3 illustrates a flowchart of an evaporation coating method according to some embodiments. The evaporation coating method utilizes an evaporation coating apparatus according to some embodiment of the present disclosure. The evaporation coating apparatus comprises an evaporator, a coating chamber, and an object holder. The object holder is configured to provide a platform for placing an object to be coated (such as a substrate) thereon. The evaporator comprises a feeding member and a heating member, wherein the feeding member is configured to store the source material and to transfer the source material to the heating member within n time periods.

The evaporation coating method can include the following steps.
Step 301: placing the source material in the feeding member and closing off the coating chamber;
Step 302: starting the heating member until the heating member has a temperature higher than a gasification temperature of the source material;
Step 303: the feeding member transferring the source material to the heating member within the n time periods, such that the source material is evaporated into a source material vapor before the source material vapor attaches to the substrate to thereby form a layer of the source material thereon.

In the evaporation coating method as described above, by means of the feeding member which can feed the source material to the heating member 12 within the n time periods, the issue of source material carbonization and the consequent negative effects on the evaporation coating process that is due to the piling up of a relatively large amount of source material in the heating member, and to an uneven heating by the heating member as well, can be effectively solved.

By means of the evaporation coating method as mentioned above, because there is a relatively small amount of source material for evaporation in the heating member, a relatively even heating can be realized, the source material is thus not subject to carbonization, ensuring that the evaporation coating process can normally proceed.

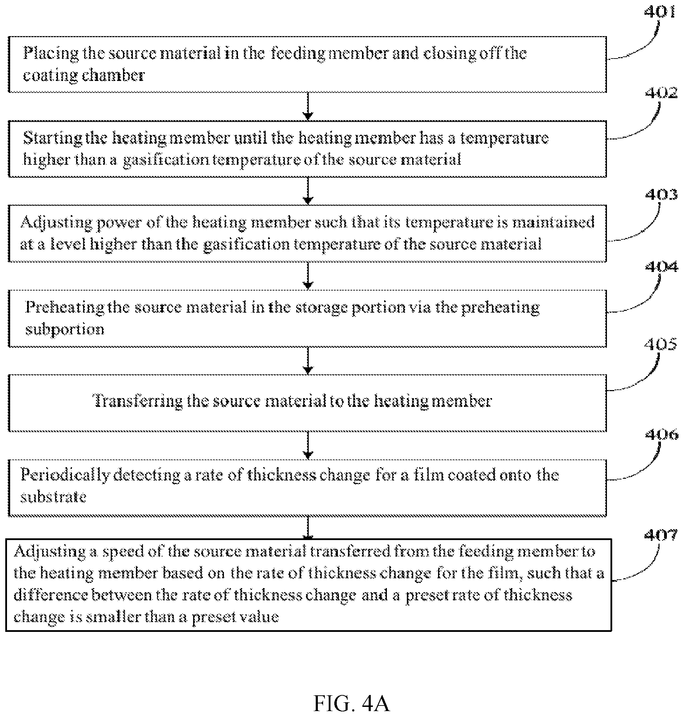

FIG. 4A illustrates a flowchart of an evaporation coating method according to some other embodiments of the present disclosure. The evaporation coating method utilizes an evaporation coating apparatus according to some embodiments of the present disclosure, which comprises an evaporator, a coating chamber, and an object holder. The object holder is configured to provide a platform for placing an object to be coated (such as a substrate) thereon. The evaporator comprises a feeding member and a heating member, wherein the feeding member is configured to store the source material and to transfer the source material to the heating member within n consecutive time periods.

The evaporation coating method can include the following steps.

Step 401: placing the source material in the feeding member and closing off the coating chamber.

When applying the evaporation coating method disclosed herein, the source material can be placed in the feeding member prior to the coating chamber is closed off. If there are more than one feeding member in the evaporation coating apparatus, the source material in each of the feeding members can have a same or a different parameter. The parameter can comprise at least one of a composition and a grain size of the source material.

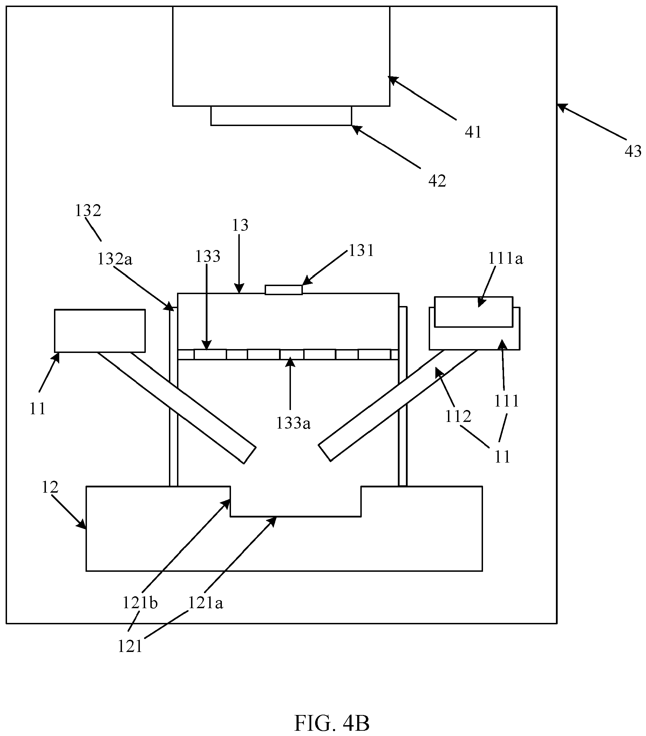

In an example of the evaporation coating apparatus as shown in FIG. 4B, the reference numbers 41, 42 and 43 are respectively referred to as an object holder (41), an object (such as a substrate) to be coated (42), and a coating chamber (43). In Step 401, the source material can be placed in the feeding member 11 before the coating chamber 43 is closed off. Other reference numbers in FIG. 4B can be referenced to FIG. 2A.

Step 402: starting the heating member until a temperature of the heating member is higher than a gasification temperature of the source material.

After the coating chamber is closed off, the heating member can be started to increase the temperature of the heating member to a level higher than the gasification temperature of the source material.

Step 403: adjusting a power of the heating member such that the temperature of the heating member is maintained at a level higher than the gasification temperature of the source material;
After the heating member is started, its power can be adjusted to maintain the temperature of the heating member at a level higher than the gasification temperature of the source material, which can avoid a decrease of the temperature of the heating member caused by the subsequent addition of the source material. The decrease of the temperature of the heating member can negatively influence the evaporation of the source material.

Step 404: preheating the source material in the storage portion via the preheating subportion.

Before the source material is transferred to the heating member, the source material in the storage portion can be preheated via the preheating subportion 111a. The process of preheating can avoid a sharp increase of the temperature of the source material after the source material enters the heating member 12, which can damage the source material. The preheating temperature can be around 80 °C or around 50 °C. The preheating subportion 111a can comprise a first heating wire surrounding the storage portion 111.

The feeding member 11 can comprise a storage portion 111, and a transferring portion 112, wherein the storage portion 111 is configured to store the source material, the transferring portion 112 is configured to transfer the source material to the heading member 12 within the n time periods, and the storage portion 111 is provided with the preheating subportion 111a.

Step 405: transferring the source material to the heating member.

After maintaining the temperature of the heating member at a level higher than the gasification temperature of the source material, the source material can be transferred to the heating member for the n time periods. Specifically, in one embodiment of the present disclosure, the source material can be separated into 10 portions, and each portion of the source material can be transferred to the heating member each time. As such, the evaporator can generate a stable flow of source material vapor. Each of the 10 portions of the source material can have a same mass or a different mass. There are no limitations herein.

Step 406: periodically detecting a rate of thickness change for a film coated onto the substrate;
After the source material is transferred to the heating member, the rate of thickness change for the film coated onto the substrate can be periodically detected. For example, the period can be set as 2 seconds, which means that the rate of thickness change for the film coated onto the substrate can be detected every two seconds.

As such, the evaporation coating apparatus can comprise a film thickness detector, which is configured to detect the rate of thickness change for the film coated onto the substrate. The film thickness detector can be a crystal oscillator.

Step 407: adjusting a speed of the source material transferred from the feeding member to the heating member based on the rate of thickness change for the film, such that a difference between the rate of thickness change and a preset rate of thickness change is smaller than a preset value;
After detecting the rate of thickness change for the film on the substrate, then based on the rate of thickness change for the film coated on the substrate, the speed of the source material transferred from the feeding member to the heating member can be adjusted such that the difference between the rate of thickness change for the film and the preset rate of thickness change for the film is smaller than the preset value.

Herein the speed of the source material transferred from the feeding member to the heating member is referred to as the amount of the source material that is transferred from the feeding member to the heating member per unit time, and it can substantially be the amount of the source material that is transferred from the feeding member to the heating member within each time period according to one of the embodiments as described above.

Step 407 ensures a stable rate of thickness change for the film on the substrate (i.e., a stable coating of the source material on the substrate), which in turn can improve the quality of coating.

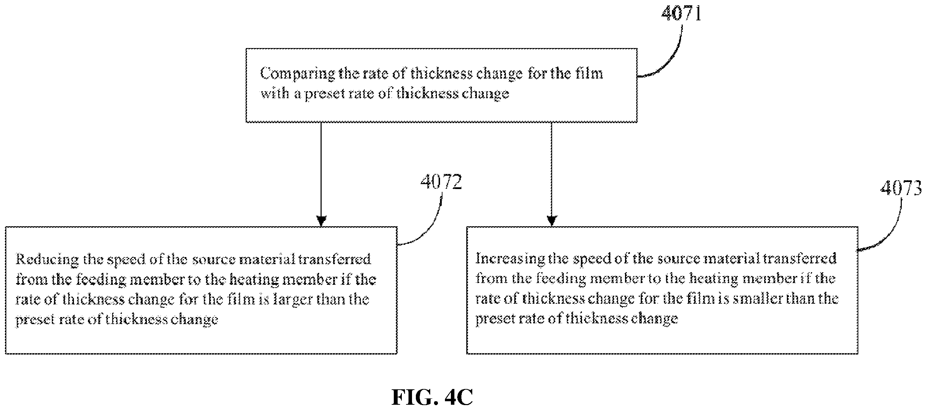

Step 407 can comprise the following three sub-steps, as shown in FIG. 4C.

Sub-step 4071: comparing the rate of thickness change for the film with a preset rate of thickness change, and executing Sub-step 4072 if the rate of thickness change for the film is larger than the preset rate of thickness change, or otherwise executing Sub-step 4072.

Herein, the preset rate of thickness change for the film can be set by an operator in advance, for example, by programming a processor or a computer, which can be part of a controller configured to control the transfer speed.

Sub-step 4072: reducing the speed of the source material that is transferred from the feeding member to the heating member if the rate of thickness change for the film is larger than the preset rate of thickness change.

If the rate of thickness change is larger than the preset rate of thickness change, the speed of the source material that is transferred from the feeding member to the heating member can be controlled to be reduced to ensure a stable coating of the source material.

Herein, the speed of the source material that is transferred from the feeding member to the heating member is referred to as the amount of the source material that is transferred from the feeding member to the heating member per unit time, and it can substantially be the amount of the source material that is transferred from the feeding member to the heating member within each time period according to one of the embodiments as described above.

Because the temperature of the heating member is maintained at a level higher than the gasification temperature of the source material, the more the source material in the heating member, the faster the evaporation speed thereof. The larger the amount of the source material that is transferred to the heating member within each time period, the more the source material in the heating member (because the density of the source material is kept unchanged). As such, if the rate of thickness change is larger than the preset rate of thickness change, the amount of the source material transferred to the heating member within each time period can be reduced to thereby reduce the difference between the rate of thickness change and the preset rate of thickness change.

Sub-step 4073: increasing the speed of the source material that is transferred from the feeding member to the heating member if the rate of thickness change for the film is smaller than the preset rate of thickness change.

If the rate of thickness change is smaller than the preset rate of thickness change, the speed of the source material that is transferred from the feeding member to the heating member can be increased to ensure a stable coating of the source material.

Herein, the speed of the source material that is transferred from the feeding member to the heating member is referred to as the amount of the source material that is transferred from the feeding member to the heating member per unit time, and it can substantially be the amount of the source material that is transferred from the feeding member to the heating member within each time period according to one of the embodiments as described above.

In the evaporation coating method as described above, by means of the feeding member which can feed the source material to the heating member 12 within the n time periods, the issue of source material carbonization and the consequent negative effects on the evaporation coating process that is due to the piling up of a relatively large amount of source material in the heating member, and to an uneven heating by the heating member as well, can be effectively solved.

By employing the evaporation coating method as mentioned above, because there is a relatively small amount of source material for evaporation in the heating member, a relatively even heating can be realized, the source material is thus not subject to carbonization, ensuring that the evaporation coating process can normally proceed.

All references cited in the present disclosure are incorporated by reference in their entirety. Although specific embodiments have been described above in detail, the description is merely for purposes of illustration. It should be appreciated, therefore, that many aspects described above are not intended as required or essential elements unless explicitly stated otherwise.

Various modifications of, and equivalent acts corresponding to, the disclosed aspects of the exemplary embodiments, in addition to those described above, can be made by a person of ordinary skill in the art, having the benefit of the present disclosure, without departing from the spirit and scope of the disclosure defined in the following claims, the scope of which is to be accorded the broadest interpretation so as to encompass such modifications and equivalent structures.

## Claims

1. An evaporator, comprising:
at least one feeding member (11), each configured to transfer a source material in a transfer speed that is adjustable; and
a heating member (12), configured to heat the source material transferred by the feeding member (11) for evaporation to thereby generate a source material vapor,
wherein each feeding member (11) comprises a storage portion (111) and a transfer portion (112), wherein:
the storage portion (111) is configured to store the source material before transferring to the transfer portion (112); and
the transfer portion (112) is configured to transfer the source material from the storage portion (111) to the heating member (12),
wherein the evaporator further comprises an evaporation chamber, wherein:
the heating member (12) is disposed inside the evaporation chamber (13);
the storage portion (111) of each feeding member (11) is disposed outside the evaporation chamber (13); and
the evaporation chamber (13) is provided with a vapor outlet (131), configured to vent the source material vapor out of the evaporation chamber (13) for subsequent coating onto a substrate,
**characterized in that** the evaporation chamber (13) comprises a vapor flow stabilizing plate (133), wherein:
the vapor flow stabilizing plate (133) is disposed inside the evaporation chamber (13), the evaporation chamber (13) is partitioned into two cavities (A, B) by the vapor flow stabilizing plate (133), the heating member (12) is disposed in one (A) of the two cavities (A, B), and the vapor outlet (131) is connected to another one (B) of the two cavities (A, B); and
the vapor flow stabilizing plate (133) is provided with a plurality of openings (133a), configured to allow the source material vapor generated from the heating member (12) to move therethrough to subsequently vent out of the evaporation chamber (13) through the vapor outlet (131),
each opening (133a) of the vapor flow stabilizing plate (133) has a substantially same size and shape; and a region closer to a center of the vapor flow stabilizing plate (133) is configured to have a higher distribution density of openings (133a).

2. The evaporator of Claim 1, wherein each feeding member (11) is configured to transfer the source material to the heating member (12) in portions, wherein:
each portion of the source material is transferred to the heating member (12) in a time period; and
the time period for each portion is adjustable to thereby realize that the transfer speed is adjustable.

3. The evaporator of Claim 2, wherein:
each feeding member (11) comprises a dispenser, configured to adjustably dispense grains of the source material to allow the source material to be transferred to the heating member (12).

4. The evaporator of Claim 3, wherein the dispenser comprises a vane wheel (112b), configured to rotate to thereby dispense the grains of the source material for transferring to the heating member (12).

5. The evaporator of Claim 4, wherein the vane wheel (112b) is coupled with a controller, configured to adjust a rotation speed of the vane wheel (112b) to thereby realize that the transfer speed of the source material is adjustable.

6. The evaporator of Claim 1, wherein the storage portion (111) comprises a preheating subportion (111a), configured to preheat the source material in the storage portion (111).

7. The evaporator of Claim 1, the evaporation chamber (13) is provided with a temperature controlling portion (132), configured to maintain a temperature of the evaporation chamber (13) to thereby prevent the source material vapor from solidifying on an inner side of the evaporation chamber (13),
wherein the temperature controlling portion (132) comprises a heating wire surrounding the evaporation chamber (13).

8. The evaporator of Claim 1, wherein the heating member (12) comprises a heating groove (121), wherein:
the source material from the at least one feeding member (11) is transferred into the heating groove (121); and
the heating groove (121) comprises a bottom wall (121a), and a side wall (121b) surrounding an edge of the bottom wall (121a), wherein the bottom wall (121a) and the side wall (121b) are configured to be both able to heat,
wherein each feeding member (11) is configured to transfer a source material of a parameter, wherein the parameter comprises at least one of a composition, a shape, or a size.

9. An evaporation coating apparatus, comprising an evaporator according to any one of Claims 1-8.

10. The evaporation coating apparatus according to Claim 9, further comprising a coating chamber, an object holder, and a controller configured to control the transfer speed; wherein:
the evaporator and the object holder are both disposed inside the coating chamber;
the object holder is configured to provide a platform for placing an object to be coated thereon; and
the coating chamber is configured to provide an environment for the source material vapor vented out from the evaporator to attach to the object to thereby form a film of the source material onto the object.

11. The evaporation coating apparatus according to Claim 10, further comprising a film thickness detector, configured to detect a rate of thickness change for the film of the source material coated onto the substrate,
wherein the film thickness detector comprises a crystal oscillator.

12. A method for evaporation coating of a source material on an object utilizing an evaporation coating apparatus, wherein the evaporation coating apparatus comprises an evaporator, a coating chamber, and an object holder, wherein the evaporator comprising at least one feeding member (11) and a heating member (12), the method comprising:
placing the source material in the at least one feeding member (11) and closing off the coating chamber (301);
starting the heating member (12) until a temperature of the heating member (12) is higher than a gasification temperature of the source material (302); and
the at least one feeding member (11) transferring the source material to the heating member (12) in a transfer speed that is adjustable to thereby obtain a source material vapor before the source material vapor attaches to the object to thereby form a film of the source material thereon (303),
wherein the heating member (12) is configured to heat the source material transferred by the feeding member (11) for evaporation to thereby generate the source material vapor,
wherein each feeding member (11) comprises a storage portion (111) and a transfer portion (112), wherein:
the storage portion (111) is configured to store the source material before transferring to the transfer portion (112); and
the transfer portion (112) is configured to transfer the source material from the storage portion (111) to the heating member (12),
wherein the evaporator further comprises an evaporation chamber, wherein:
the heating member (12) is disposed inside the evaporation chamber (13);
the storage portion (111) of each feeding member (11) is disposed outside the evaporation chamber (13); and
the evaporation chamber (13) is provided with a vapor outlet (131), configured to vent the source material vapor out of the evaporation chamber (13) for subsequent coating onto a substrate,
**characterized in that** the evaporation chamber (13) comprises a vapor flow stabilizing plate (133), wherein:
the vapor flow stabilizing plate (133) is disposed inside the evaporation chamber (13), the evaporation chamber (13) is partitioned into two cavities (A, B) by the vapor flow stabilizing plate (133), the heating member (12) is disposed in one (A) of the two cavities (A, B), and the vapor outlet (131) is connected to another one (B) of the two cavities (A, B); and
the vapor flow stabilizing plate (133) is provided with a plurality of openings (133a), configured to allow the source material vapor generated from the heating member (12) to move therethrough to subsequently vent out of the evaporation chamber (13) through the vapor outlet (131),
each opening (133a) of the vapor flow stabilizing plate (133) has a substantially same size and shape; and a region closer to a center of the vapor flow stabilizing plate (133) is configured to have a higher distribution density of openings (133a).

13. The method according to Claim 12, further comprising, between the starting the heating member (12) until a temperature of the heating member (12) is higher than a gasification temperature of the source material and the at least one feeding member (11) transferring the source material to the heating member (12) in a transfer speed that is adjustable:
adjusting a power of the heating member (12) such that the temperature of the heating member (12) is maintained at a level higher than the gasification temperature of the source material (403).

14. The method according to Claim 12, further comprising, prior to the at least one feeding member (11) transferring the source material to the heating member (12) in a transfer speed that is adjustable:
preheating the source material (404).

15. The method according to Claim 12, wherein:
the evaporation coating apparatus further comprises a film thickness detector configured to detect a rate of thickness change for the film of the source material coated onto the object; and
the at least one feeding member (11) transferring the source material to the heating member (12) in a transfer speed that is adjustable comprises:
the at least one feeding member (11) transferring the source material to the heating member (12) (405);
periodically detecting a rate of thickness change for the film of the source material coated onto the object (406); and
adjusting a transfer speed of the source material based on the rate of thickness change for the film of the source material, such that a difference between the rate of thickness change and a preset rate of thickness change is smaller than a preset value (407),
wherein the adjusting a transfer speed of the source material based on the rate of thickness change for the film of the source material comprises:
comparing the rate of thickness change for the film of the source material with a preset rate of thickness change (4071); and
reducing the transfer speed of the source material if the rate of thickness change for the film of the source material is larger than the preset rate of thickness change (4072); or
increasing the transfer speed of the source material if the rate of thickness change for the film of the source material is smaller than the preset rate of thickness change (4073).

## Patentansprüche

1. Verdampfer, umfassend:
mindestens ein Zufuhrelement (11), das jeweils dafür eingerichtet ist, ein Ausgangsmaterial mit einer einstellbaren Transfergeschwindigkeit zu transferieren; und
ein Heizelement (12), das dafür eingerichtet ist, dass durch das Zufuhrelement (11) transferierte Ausgangsmaterial zum Verdampfen zu erwärmen, um dadurch einen Ausgangsmaterialdampf zu generieren,
wobei jedes Zufuhrelement (11) einen Speicherabschnitt (111) und einen Transferabschnitt (112) umfasst, wobei:
der Speicherabschnitt (111) dafür eingerichtet ist, das Ausgangsmaterial zu speichern, bevor es zu dem Transferabschnitt (112) transferiert wird; und
der Transferabschnitt (112) dafür eingerichtet ist, das Ausgangsmaterial von dem Speicherabschnitt (111) zu dem Heizelement (12) zu transferieren,
wobei der Verdampfer des Weiteren eine Verdampfungskammer umfasst, wobei:
das Heizelement (12) im Inneren der Verdampfungskammer (13) angeordnet ist;
der Speicherabschnitt (111) jedes Zufuhrelements (11) außerhalb der Verdampfungskammer (13) angeordnet ist; und die Verdampfungskammer (13) mit einem Dampfauslass (131) versehen ist, der dafür eingerichtet ist, den Ausgangsmaterialdampf aus der Verdampfungskammer (13) zum anschließenden Beschichten auf ein Substrat auszulassen, **dadurch gekennzeichnet, dass** die Verdampfungskammer (13) eine Dampfstromstabilisierungsplatte (133) umfasst, wobei:
die Dampfstromstabilisierungsplatte (133) innerhalb der Verdampfungskammer (13) angeordnet ist, die Verdampfungskammer (13) durch die Dampfstromstabilisierungsplatte (133) in zwei Hohlräume (A, B) unterteilt ist, das Heizelement (12) in einem (A) der beiden Hohlräume (A, B) angeordnet ist und der Dampfauslass (131) mit einem anderen (B) der beiden Hohlräume (A, B) verbunden ist; und
die Dampfstromstabilisierungsplatte (133) mit mehreren Öffnungen (133a) versehen ist, die dafür eingerichtet sind, es dem von dem Heizelement (12) generierten Ausgangsmaterialdampf zu gestatten, sich dort hindurch zu bewegen, um anschließend durch den Dampfauslass (131) hindurch aus der Verdampfungskammer (13) abgelassen zu werden,
jede Öffnung (133a) der Dampfstromstabilisierungsplatte (133) eine im Wesentlichen gleiche Größe und Form hat; und eine Region, die näher an einer Mitte der Dampfstromstabilisierungsplatte (133) liegt, dafür eingerichtet ist, eine höhere Verteilungsdichte von Öffnungen (133a) aufzuweisen.

2. Verdampfer nach Anspruch 1, wobei jedes Zufuhrelement (11) dafür eingerichtet ist, dass Ausgangsmaterial schubweise zu dem Heizelement (12) zu transferieren, wobei:
jeder Schub des Ausgangsmaterials innerhalb eines Zeitraums zu dem Heizelement (12) transferiert wird; und
der Zeitraum für jeden Schub einstellbar ist, um dadurch zu realisieren, dass die Transfergeschwindigkeit einstellbar ist.

3. Verdampfer nach Anspruch 2, wobei:
jedes Zufuhrelement (11) eine Abgabevorrichtung umfasst, die dafür eingerichtet ist, auf einstellbare Weise Körner des Ausgangsmaterials abzugeben, so dass das Ausgangsmaterial zu dem Heizelement (12) transferiert werden kann.

4. Verdampfer nach Anspruch 3, wobei die Abgabevorrichtung ein Schaufelrad (112b) umfasst, das dafür eingerichtet ist, sich zu drehen, um dadurch die Körner des Ausgangsmaterials zum Transferieren zu dem Heizelement (12) abzugeben.

5. Verdampfer nach Anspruch 4, wobei das Schaufelrad (112b) mit einem Controller gekoppelt ist, der dafür eingerichtet ist, eine Rotationsgeschwindigkeit des Schaufelrades (112b) einzustellen, um dadurch zu realisieren, dass die Transfergeschwindigkeit des Ausgangsmaterials einstellbar ist.

6. Verdampfer nach Anspruch 1, wobei der Speicherabschnitt (111) einen Vorwärm-Teilabschnitt (111a) umfasst, der dafür eingerichtet ist, das Ausgangsmaterial in dem Speicherabschnitt (111) vorzuwärmen.

7. Verdampfer nach Anspruch 1, wobei die Verdampfungskammer (13) mit einem Temperatursteuerungsabschnitt (132) versehen ist, der dafür eingerichtet ist, eine Temperatur der Verdampfungskammer (13) aufrecht zu erhalten, um dadurch zu verhindern, dass der Ausgangsmaterialdampf an einer Innenseite der Verdampfungskammer (13) erstarrt,
wobei der Temperatursteuerungsabschnitt (132) einen Heizdraht umfasst, der die Verdampfungskammer (13) umgibt.

8. Verdampfer nach Anspruch 1, wobei das Heizelement (12) eine Heizrinne (121) umfasst, wobei:
das Ausgangsmaterial von dem mindestens einem Zufuhrelement (11) in die Heizrinne (121) transferiert wird; und
die Heizrinne (121) eine Bodenwand (121a) und eine Seitenwand (121b), die einen Rand der Bodenwand (121a) umgibt, umfasst, wobei die Bodenwand (121a) und die Seitenwand (121b) dafür eingerichtet sind, beide heizen können,
wobei jedes Zufuhrelement (11) dafür eingerichtet ist, ein Ausgangsmaterial gemäß einem Parameter zu transferieren, wobei der Parameter mindestens eines von einer Zusammensetzung, einer Form und einer Größe umfasst.

9. Aufdampfungsvorrichtung, umfassend einen Verdampfer nach einem der Ansprüche 1 bis 8.

10. Aufdampfungsvorrichtung nach Anspruch 9, umfassend des Weiteren eine Beschichtungskammer, einen Objekthalter und einen Controller, der dafür eingerichtet ist, die Transfergeschwindigkeit zu steuern, wobei:
der Verdampfer und der Objekthalter beide im Inneren der Beschichtungskammer angeordnet sind;
der Objekthalter dafür eingerichtet ist, eine Plattform zum Platzieren eines zu beschichtenden Objekts bereitzustellen; und
die Beschichtungskammer dafür eingerichtet ist, eine Umgebung bereitzustellen, in der sich der aus dem Verdampfer abgelassene Ausgangsmaterialdampf an dem Objekt ablagern kann, um dadurch einen Film des Ausgangsmaterials auf dem Objekt zu bilden.

11. Aufdampfungsvorrichtung nach Anspruch 10, umfassend des Weiteren einen Filmdickendetektor, der dafür eingerichtet ist, eine Rate der Dickenänderung für den auf das Substrat aufbeschichteten Film des Ausgangsmaterials zu detektieren, wobei der Filmdickendetektor einen Kristalloszillator umfasst.

12. Verfahren zum Aufdampfen eines Ausgangsmaterials auf ein Objekt unter Verwendung einer Aufdampfungsvorrichtung, wobei die Aufdampfungsvorrichtung einen Verdampfer, eine Beschichtungskammer und einen Objekthalter umfasst, wobei der Verdampfer mindestens ein Zufuhrelement (11) und ein Heizelement (12) umfasst, wobei das Verfahren umfasst:
Platzieren des Ausgangsmaterials in das mindestens ein Zufuhrelement (11) und Verschließen der Beschichtungskammer (301) ;
Starten des Heizelements (12), bis eine Temperatur des Heizelements (12) höher ist als eine Vergasungstemperatur des Ausgangsmaterials (302); und
wobei das mindestens ein Zufuhrelement (11) das Ausgangsmaterial mit einer einstellbaren Transfergeschwindigkeit zu dem Heizelement (12) transferiert, um dadurch einen Ausgangsmaterialdampf zu erhalten, bevor sich der Ausgangsmaterialdampf an dem Objekt ablagert, um dadurch darauf einen Film des Ausgangsmaterials zu bilden (303),
wobei das Heizelement (12) dafür eingerichtet ist, dass durch das Zufuhrelement (11) transferierte Ausgangsmaterial zum Verdampfen zu erwärmen, um dadurch den Ausgangsmaterialdampf zu generieren,
wobei jedes Zufuhrelement (11) einen Speicherabschnitt (111) und einen Transferabschnitt (112) umfasst, wobei:
der Speicherabschnitt (111) dafür eingerichtet ist, das Ausgangsmaterial zu speichern, bevor es zu dem Transferabschnitt (112) transferiert wird; und
der Transferabschnitt (112) dafür eingerichtet ist, das Ausgangsmaterial von dem Speicherabschnitt (111) zu dem Heizelement (12) zu transferieren,
wobei der Verdampfer des Weiteren eine Verdampfungskammer umfasst, wobei:
das Heizelement (12) im Inneren der Verdampfungskammer (13) angeordnet ist;
der Speicherabschnitt (111) jedes Zufuhrelements (11) außerhalb der Verdampfungskammer (13) angeordnet ist; und die Verdampfungskammer (13) mit einem Dampfauslass (131) versehen ist, der dafür eingerichtet ist, den Ausgangsmaterialdampf aus der Verdampfungskammer (13) zum anschließenden Beschichten auf ein Substrat auszulassen,
**dadurch gekennzeichnet, dass** die Verdampfungskammer (13) eine Dampfstromstabilisierungsplatte (133) umfasst, wobei:
die Dampfstromstabilisierungsplatte (133) innerhalb der Verdampfungskammer (13) angeordnet ist, die Verdampfungskammer (13) durch die Dampfstromstabilisierungsplatte (133) in zwei Hohlräume (A, B) unterteilt ist, das Heizelement (12) in einem (A) der beiden Hohlräume (A, B) angeordnet ist und der Dampfauslass (131) mit einem anderen (B) der beiden Hohlräume (A, B) verbunden ist; und
die Dampfstromstabilisierungsplatte (133) mit mehreren Öffnungen (133a) versehen ist, die dafür eingerichtet sind, es dem von dem Heizelement (12) generierten Ausgangsmaterialdampf zu gestatten, sich dort hindurch zu bewegen, um anschließend durch den Dampfauslass (131) hindurch aus der Verdampfungskammer (13) abgelassen zu werden,
jede Öffnung (133a) der Dampfstromstabilisierungsplatte (133) eine im Wesentlichen gleiche Größe und Form hat; und eine Region, die näher an einer Mitte der Dampfstromstabilisierungsplatte (133) liegt, dafür eingerichtet ist, eine höhere Verteilungsdichte von Öffnungen (133a) aufzuweisen.

13. Verfahren nach Anspruch 12, umfassend des Weiteren zwischen dem Starten des Heizelements (12), bis eine Temperatur des Heizelements (12) höher ist als eine Vergasungstemperatur des Ausgangsmaterials, und dem Transferieren des Ausgangsmaterials mit einer einstellbaren Transfergeschwindigkeit zu dem Heizelement (12) durch das mindestens ein Zufuhrelement (11):
Einstellen einer Leistung des Heizelements (12) so, dass die Temperatur des Heizelements (12) auf einem Wert gehalten wird, der höher ist als die Vergasungstemperatur des Ausgangsmaterials (403).

14. Verfahren nach Anspruch 12, umfassend des Weiteren vor dem Transferieren des Ausgangsmaterials mit einer einstellbaren Transfergeschwindigkeit zu dem Heizelement (12) durch das mindestens ein Zufuhrelement (11):
Vorwärmen des Ausgangsmaterials (404).

15. Verfahren nach Anspruch 12, wobei:
die Aufdampfungsvorrichtung des Weiteren einen Filmdickendetektor umfasst, der dafür eingerichtet ist, eine Rate der Dickenänderung für den auf das Objekt aufbeschichteten Film des Ausgangsmaterials zu detektieren, und
das Transferieren des Ausgangsmaterials mit einer einstellbaren Transfergeschwindigkeit zu dem Heizelement (12) durch das mindestens ein Zufuhrelement (11) umfasst:
Transferieren des Ausgangsmaterials zu dem Heizelement (12) durch das mindestens ein Zufuhrelement (11) (405);
periodisches Detektieren einer Rate der Dickenänderung für den auf das Objekt aufbeschichteten Film des Ausgangsmaterials (406); und
Einstellen einer Transfergeschwindigkeit des Ausgangsmaterials auf der Grundlage der Rate der Dickenänderung für den Film des Ausgangsmaterials, dergestalt, dass eine Differenz zwischen der Rate der Dickenänderung und einer voreingestellten Rate der Dickenänderung kleiner als ein voreingestellter Wert ist (407),
wobei das Einstellen einer Transfergeschwindigkeit des Ausgangsmaterials auf der Grundlage der Rate der Dickenänderung für den Film des Ausgangsmaterials umfasst:
Vergleichen der Rate der Dickenänderung für den Film des Ausgangsmaterials mit einer voreingestellten Rate der Dickenänderung (4071); und
Verringern der Transfergeschwindigkeit des Ausgangsmaterials, falls die Rate der Dickenänderung für den Film des Ausgangsmaterials größer ist als die voreingestellte Rate der Dickenänderung (4072); oder
Erhöhen der Transfergeschwindigkeit des Ausgangsmaterials, falls die Rate der Dickenänderung für den Film des Ausgangsmaterials kleiner ist als die voreingestellte Rate der Dickenänderung (4073).

## Revendications

1. Évaporateur, comprenant :
au moins un élément d'alimentation (11), chacun étant configuré pour transférer une matière source à une vitesse de transfert qui est réglable ; et
un élément chauffant (12), configuré pour chauffer la matière source transférée par l'élément d'alimentation (11) en vue d'une évaporation pour ainsi générer une vapeur de matière source,
dans lequel chaque élément d'alimentation (11) comprend une partie de stockage (111) et une partie de transfert (112), dans lequel :
la partie de stockage (111) est configurée pour stocker la matière source avant un transfert vers la partie de transfert (112) ; et
la partie de transfert (112) est configurée pour transférer la matière source de la partie de stockage (111) à l'élément chauffant (12),
dans lequel l'évaporateur comprend en outre une chambre d'évaporation, dans lequel :
l'élément chauffant (12) est disposé à l'intérieur de la chambre d'évaporation (13) ;
la partie de stockage (111) de chaque élément d'alimentation (111) est disposée à l'extérieur de la chambre d'évaporation (13) ; et
la chambre d'évaporation (13) est munie d'une sortie de vapeur (131), configurée pour évacuer la vapeur de matière source hors de la chambre d'évaporation (13) en vue d'un dépôt ultérieur sur un substrat,
**caractérisé en ce que** la chambre d'évaporation (13) comprend une plaque de stabilisation de flux de vapeur (133), dans lequel :
la plaque de stabilisation de flux de vapeur (133) est disposée à l'intérieur de la chambre d'évaporation (13), la chambre d'évaporation (13) est séparée en deux cavités (A, B) par la plaque de stabilisation de flux de vapeur (133), l'élément chauffant (12) est disposé dans l'une (A) des deux cavités (A, B), et la sortie de vapeur (131) est reliée à l'autre (B) des deux cavités (A, B) ; et
la plaque de stabilisation de flux de vapeur (133) est munie d'une pluralité d'ouvertures (133a), configurées pour permettre à la vapeur de matière source générée à partir de l'élément chauffant (12) de passer à travers ceux-ci pour être ensuite évacuée hors de la chambre de l'évaporation (13) à travers la sortie de vapeur (131), chaque ouverture (133a) de la plaque de stabilisation de flux de vapeur (133) a une taille et une forme sensiblement identiques ; et une zone plus proche d'un centre de la plaque de stabilisation de flux de vapeur (133) est configurée pour avoir une densité de répartition des ouvertures (133a) plus élevée.

2. Évaporateur selon la revendication 1, dans lequel chaque élément d'alimentation (111) est configuré pour transférer la matière source vers l'élément chauffant (12) par portions ; dans lequel :
chaque partie de la matière source est transférée vers l'élément chauffant (12) sur une période de temps ; et
la période de temps pour chaque partie est réglable pour ainsi permettre que la vitesse de transfert soit réglable.

3. Évaporateur selon la revendication 2, dans lequel :
chaque élément d'alimentation (11) comprend un distributeur, configuré pour distribuer des grains de la matière source de manière réglable pour permettre de transférer la matière source vers l'élément chauffant (12).

4. Évaporateur selon la revendication 3, dans lequel le distributeur comprend une roue à aubes (112b), configurée pour tourner pour ainsi distribuer les grains de la matière source en vue d'un transfert vers l'élément chauffant (12).

5. Évaporateur selon la revendication 4, dans lequel la roue à aubes (112b) est couplée à une commande, configurée pour régler une vitesse de rotation de la roue à aubes (112b) pour ainsi permettre que la vitesse de transfert de la matière source soit réglable.

6. Évaporateur selon la revendication 1, dans lequel la partie de stockage (111) comprend une sous-partie de préchauffage (111a), configurée pour préchauffer la matière source dans la partie de stockage (111).

7. Évaporateur selon la revendication 1, la chambre d'évaporation (13) étant munie d'une partie de commande de température (132), configurée pour maintenir une température de la chambre d'évaporation (13) pour ainsi empêcher la vapeur de matière source de se solidifier sur un côté intérieur de la chambre d'évaporation (13),
dans lequel la partie de commande de température (132) comprend un fil chauffant entourant la chambre d'évaporation (13).

8. Évaporateur selon la revendication 1, dans lequel l'élément chauffant (12) comprend une rainure de chauffage (121), dans lequel :
la matière source provenant du au moins un élément d'alimentation (11) est transférée dans la rainure de chauffage (121) ; et
la rainure de chauffage (121) comprend une paroi de fond (121a) et une paroi latérale (121b) entourant un bord de la paroi de fond (121a), dans lequel la paroi de fond (121a) et la paroi latérale (121b) sont configurées pour pouvoir toutes deux chauffer,
dans lequel chaque élément d'alimentation (11) est configuré pour transférer une matière source d'un paramètre, dans lequel le paramètre comprend au moins un élément parmi une composition, une forme ou une taille.

9. Appareil de dépôt par évaporation, comprenant un évaporateur selon l'une quelconque des revendications 1 à 8.

10. Appareil de dépôt par évaporation selon la revendication 9, comprenant en outre une chambre de dépôt, un porte-objet et une commande configurée pour commander la vitesse de transfert ; dans lequel :
l'évaporateur et le porte-objet sont tous deux disposés à l'intérieur de la chambre de dépôt ;
le porte-objet est configuré pour fournir une plate-forme destinée à placer un objet à revêtir sur celui-ci ; et
la chambre de dépôt est configurée pour fournir un environnement pour la vapeur de matière source évacuée hors de l'évaporateur pour qu'elle se fixe sur l'objet pour ainsi former un film de la matière source sur l'objet.

11. Appareil de dépôt par évaporation selon la revendication 10, comprenant en outre un détecteur d'épaisseur de film, configuré pour détecter une vitesse de variation d'épaisseur du film de la matière source déposée sur le substrat,
dans lequel le détecteur d'épaisseur de film comprend un oscillateur à cristaux.

12. Procéder de dépôt par évaporation d'une matière source sur un objet utilisant un appareil de dépôt par évaporation, dans lequel l'appareil de dépôt par évaporation comprend un évaporateur, une chambre de dépôt et un porte-objet, dans lequel l'évaporateur comprend au moins un élément d'alimentation (11) et un élément chauffant (12), le procédé comprenant de :
placer la matière source dans le au moins un élément d'alimentation (11) et fermer la chambre de dépôt (301) ; démarrer l'élément chauffant (12) jusqu'à ce qu'une température de l'élément chauffant (12) soit supérieure à une température de gazéification de la matière source (302) ; et
le au moins un élément d'alimentation (111) transférant la matière source vers l'élément chauffant (12) à une vitesse de transfert qui est réglable pour ainsi obtenir une vapeur de matière source avant que la vapeur de matière source se fixe sur l'objet pour ainsi former un film de la matière source sur celui-ci (303),
dans lequel l'élément chauffant (12) est configuré pour chauffer la matière source transférée par l'élément d'alimentation (11) en vue d'une évaporation pour ainsi générer la vapeur de matière source,
dans lequel chaque élément d'alimentation (11) comprend une partie de stockage (111) et une partie de transfert (112), dans lequel :
la partie de stockage (111) est configurée pour stocker la matière source avant un transfert vers la partie de transfert (112) ; et
la partie de transfert (112) est configurée pour transférer la matière source de la partie de stockage (111) à l'élément chauffant (12),
dans lequel l'évaporateur comprend en outre une chambre d'évaporation, dans lequel :
l'élément chauffant (12) est disposé à l'intérieur de la chambre d'évaporation (13) ;
la partie de stockage (111) de chaque élément d'alimentation (111) est disposée à l'extérieur de la chambre d'évaporation (13) ; et
la chambre d'évaporation (13) est munie d'une sortie de vapeur (131), configurée pour évacuer la vapeur de matière source hors de la chambre d'évaporation (13) en vue d'un dépôt ultérieur sur un substrat,
**caractérisé en ce que** la chambre d'évaporation (13) comprend une plaque de stabilisation de flux de vapeur (133), dans lequel :
la plaque de stabilisation de flux de vapeur (133) est disposée à l'intérieur de la chambre d'évaporation (13), la chambre d'évaporation (13) est séparée en deux cavités (A, B) par la plaque de stabilisation de flux de vapeur (133), l'élément chauffant (12) est disposé dans l'une (A) des deux cavités (A, B), et la sortie de vapeur (131) est reliée à l'autre (B) des deux cavités (A, B) ; et
la plaque de stabilisation de flux de vapeur (133) est munie d'une pluralité d'ouvertures (133a), configurées pour permettre à la vapeur de matière source générée à partir de l'élément chauffant (12) de passer à travers ceux-ci pour être ensuite évacuée hors de la chambre de l'évaporation (13) à travers la sortie de vapeur (131), chaque ouverture (133a) de la plaque de stabilisation de flux de vapeur (133) a une taille et une forme sensiblement identiques ; et une zone plus proche d'un centre de la plaque de stabilisation de flux de vapeur (133) est configurée pour avoir une densité de répartition des ouvertures (133a) plus élevée.

13. Procédé selon la revendication 12, comprenant en outre, entre le démarrage de l'élément chauffant (12) jusqu'à ce qu'une température de l'élément chauffant (12) soit supérieure à une température de gazéification de la matière source et le au moins un élément d'alimentation (11) transférant la matière source vers l'élément chauffant (12) à une vitesse de transfert qui est réglable, de :
régler une puissance de l'élément chauffant (12) de telle sorte que la température de l'élément chauffant (12) est maintenue à un niveau plus élevé que la température de gazéification de la matière source (403).

14. Procédé selon la revendication 12, comprenant en outre, avant le au moins un élément d'alimentation (11) transférant la matière source vers l'élément chauffant (12) à une vitesse de transfert qui est réglable, de :
préchauffer la matière source (404).

15. Procédé selon la revendication 12, dans lequel :
l'appareil de dépôt par évaporation comprend en outre un détecteur d'épaisseur de film configuré pour détecter une vitesse de variation d'épaisseur du film de la matière source déposée sur l'objet ; et
le au moins un élément d'alimentation (11) transférant la matière source vers l'élément chauffant (12) à une vitesse de transfert qui est réglable, comprend de :
transférer, par le au moins un élément d'alimentation (11), la matière source vers l'élément chauffant (12) (405) ;
détecter périodiquement une vitesse de variation d'épaisseur du film de la matière source déposée sur l'objet( 406) ; et
régler une vitesse de transfert de la matière source sur la base de la vitesse de variation d'épaisseur du film de la matière source, de telle sorte qu'une différence entre la vitesse de variation d'épaisseur et une vitesse prédéfinie de variation d'épaisseur est inférieure à une valeur prédéfinie (407),
dans lequel le réglage d'une vitesse de transfert de la matière source sur la base de la vitesse de variation d'épaisseur du film de la matière source comprend de :
comparer la vitesse de variation d'épaisseur du film de la matière source avec une vitesse de variation d'épaisseur prédéfinie (4071) ; et
réduire la vitesse de transfert de la matière source si la vitesse de variation d'épaisseur du film de la matière source est supérieure à la vitesse de variation d'épaisseur prédéfinie (4072) ; ou
augmenter la vitesse de transfert de la matière source si la vitesse de variation d'épaisseur du film de la matière source est inférieure à la vitesse de variation d'épaisseur prédéfinie (4073) .
